# FASCICULE DE BREVET EUROPEEN

(11) **EP 3 664 294 B1**
(45) Date de publication et mention de la délivrance du brevet: **27.12.2023**
(21) Numéro de dépôt: 19210170.7
(22) Date de dépôt: 19.11.2019
(51) Int. Cl.: H03K 17/082, H02H 3/00

(54) **DISPOSITIF DE PROTECTION D'UN CIRCUIT DE SERVITUDE, ET DISPOSITIF DE MESURE D'UN COURANT DANS UN CIRCUIT ÉLECTRIQUE METTANT EN OEUVRE UN TEL DISPOSITIF DE PROTECTION**
SCHUTZVORRICHTUNG EINES VERSORGUNGSSYSTEMS UND MESSVORRICHTUNG EINES STROMS IN EINEM ELEKTRISCHEN SCHALTKREIS, DER EINE SOLCHE SCHUTZVORRICHTUNG VERWENDET
DEVICE FOR PROTECTING A UTILITY CIRCUIT, AND DEVICE FOR MEASURING A CURRENT IN AN ELECTRICAL CIRCUIT USING SUCH A PROTECTION DEVICE

(30) Priorité: 06.12.2018 FR 1872353
(43) Date de publication de la demande: 10.06.2020
(73) Titulaire: NEXTER Systems, 78034 Versailles Cedex (FR)
(72) Inventeur: DEGOUTTE, Cédric, 18023 BOURGES (FR); DECROUX, Philippe, 18023 BOURGES (FR)
(74) Mandataire: Cabinet Chaillot

(56) Documents cités:
- CN-A- 108 275 091
- DE-A1-102017 204 052
- FR-A1- 2 742 600

## Description

La présente invention concerne le domaine des systèmes de protection des circuits de servitude et en particulier des protections des circuits de mesure de courant, et sur un dispositif de mesure d'un courant dans un circuit électrique le mettant en oeuvre.

Il est connu de mesurer la chute de tension aux bornes d'un transistor (par exemple, un transistor à effet de champ métal-oxyde-semi-conducteur (MOSFET) couramment appelé transistor MOS) dans un circuit électrique pour mesurer le courant circulant dans ce dernier. En effet, les circuits électriques dans lesquels circule un fort courant comportent généralement au niveau de leurs contacteurs des composants interrupteurs de puissance de type MOS. La résistance drain-source à l'état passant (couramment appelée R_{ON}) du transistor MOS est alors utilisée pour mesurer le courant circulant dans le circuit électrique.

Dans le cas d'une mesure de courant qui utilise la résistance à l'état passant d'un transistor à semi-conducteurs de type MOS, il est important que le circuit de mesure supporte la tension de celui-ci quand ce même transistor est ouvert.

Un circuit de servitude est un circuit qui remplit une ou plusieurs fonctions particulières, notamment mais non exclusivement une mesure de tension, une mesure de courant, une commande.

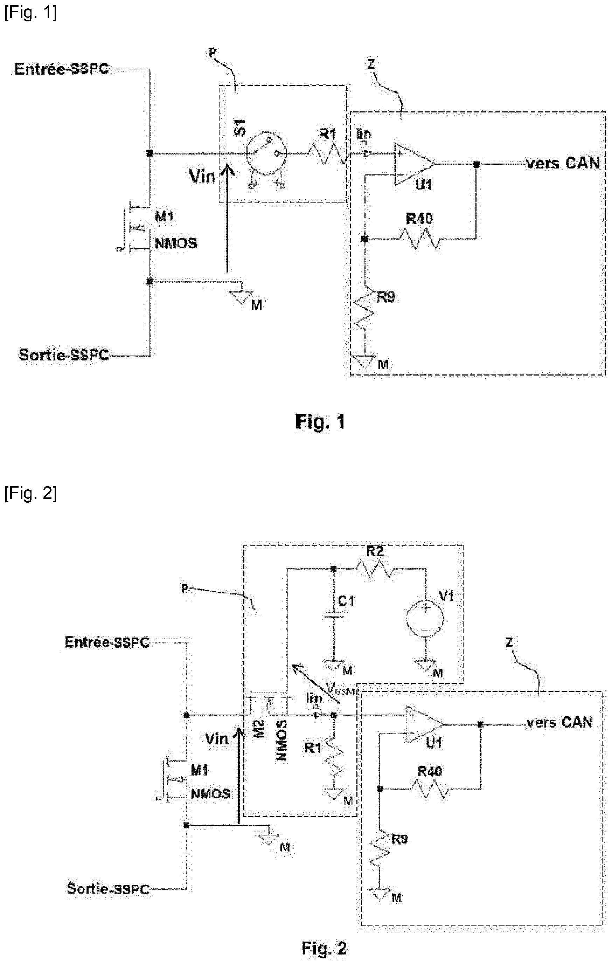

La Figure 1 représente un dispositif de mesure de courant selon l'état antérieur de la technique. Ce dispositif de mesure de courant existant comprend un transistor de puissance MOS de type N (couramment appelé NMOS) M1 incorporé en série dans un circuit électrique de type contrôleur de puissance à semi-conducteurs (SSPC) entre une entrée du SSPC (Entrée-SSPC) et une sortie du SSPC (Sortie-SSPC), la sortie (Sortie-SSPC) étant reliée à la masse M du circuit. Une tension Vin est ainsi mesurée entre le drain et la source du transistor M1. Le dispositif de mesure de courant comprend une servitude Z qui est un circuit de mesure comportant un amplificateur opérationnel U1 dont la sortie est configurée pour être reliée à un convertisseur analogique-numérique (CAN). L'amplificateur opérationnel U1 est configuré pour être utilisé en tant que circuit amplificateur de tension, une résistance R9 étant disposée entre son entrée inverseuse et la masse M, et une résistance R40 étant disposée entre son entrée inverseuse et sa sortie, le gain de l'amplificateur opérationnel U1 dépendant alors des valeurs des résistances R9 et R40, la tension à la sortie de l'amplificateur opérationnel U1 étant l'image du courant aux bornes du transistor M1 lorsque ce dernier est fermé.

Lorsque le transistor M1 est ouvert, le courant de fuite lin circulant vers l'entrée non inverseuse de l'amplificateur opérationnel U1 doit être très faible. En effet, l'amplificateur opérationnel U1 ne doit pas être détruit par la tension d'entrée Vin lorsque le transistor M1 est ouvert.

Pour des applications dont la tension du réseau de puissance est inférieure à 200 Volts, l'ajout d'une résistance série R1 en amont de l'entrée non inverseuse de l'amplificateur opérationnel U1 permet de contenir ce courant de fuite Iin.

Un dispositif de protection P sous la forme d'un contacteur S1 peut également être ajouté entre le drain du transistor M1 et la résistance R1 pour limiter le courant de fuite Iin pendant la phase d'ouverture du transistor M1, le contacteur S1 pouvant, par exemple, être réalisé à base d'un relais électromécanique ou électronique, par exemple un relais à couplage optique.

Cependant, cette configuration existante oblige à suivre un séquencement particulier au moment de l'ouverture du transistor M1. En effet, dans un premier temps, il faut ouvrir le contacteur S1, puis commander l'ouverture du transistor M1. Pour la phase de fermeture, il faut opérer dans le sens inverse.

De plus, pour des tensions supérieures à 200 Volts, le dispositif existant de la Figure 1 ne peut pas être utilisé du fait de la puissance en jeu dans la résistance R1 ou de la valeur de la résistance R1 qui ne permet plus à l'amplificateur opérationnel U1 de fonctionner, par limitation de sa bande passante. Dans le cas d'une tension importante, il faut en outre synchroniser la fermeture du contacteur S1 avec la fermeture du transistor M1, le contacteur S1 devant aussi être en mesure de supporter la tension du réseau de puissance quand le transistor M1 est ouvert.

La demande de brevet allemand DE 1 02017204052A1 divulgue un dispositif de mesure de chute de tension comprenant un dispositif de protection tel que décrit dans le préambule de la revendication 1 et similaire à celui représenté à la Figure 1 de la présente invention, ledit dispositif de protection comprenant un transistor dont la grille est pilotée à l'aide d'un signal de commutation tout ou rien délivré par une unité de commande. Cependant, ce dispositif de protection nécessite un séquencement complexe à suivre au moment de la fermeture du transistor de puissance.

La demande FR 2 742 600 A1 divulgue un dispositif de protection,

La présente invention vise à résoudre les inconvénients de l'état antérieur de la technique, en proposant un dispositif permettant la protection d'un circuit de servitude, et en particulier la protection d'un circuit de mesure de courant dans un circuit électrique, permettant ainsi de protéger l'amplificateur opérationnel lorsque le transistor de puissance est ouvert, et approprié pour un réseau haute tension.

La présente invention a donc pour objet un dispositif de mesure de courant selon la revendication 1.

Ainsi, les avantages principaux du dispositif de protection sont l'absence de moyens de commande spécifiques du transistor de protection pour permettre de mesurer le courant traversant le transistor de puissance grâce à la source de tension continue reliée en permanence à la grille du transistor de protection, et la possibilité de contrôler la phase transitoire de fermeture en cas de charge en court-circuit au moment de la fermeture du transistor de puissance.

Dans le dispositif de protection selon la présente invention, le transistor de protection reste ouvert tant que la tension aux bornes du transistor de puissance est trop importante pour le circuit de servitude.

Quand le transistor de puissance est ouvert, un courant s'établit à travers le transistor de protection afin de respecter l'équation suivante : V_{GSM2} = V1 - V_{R1}, où V_{GSM2} est la tension entre la grille et la source du transistor de protection, V1 est la tension continue de la première source de tension, et V_{R1} est la tension aux bornes de la première résistance. Le point d'équilibre est atteint lorsque la tension V_{GSM2} est égale à la tension de seuil de grille du transistor de protection. Le choix de la valeur de la tension de la première source de tension continue V1 et de la valeur de la première résistance R1 permet ainsi de limiter la tension V_{R1} à une tension acceptable pour l'entrée du circuit de servitude.

Lorsqu'il est ouvert, la tension aux bornes du transistor de puissance est supérieure à V_{R1} + V_{GSM2} alors le transistor de protection reste ouvert et protège le circuit de servitude.

Au moment de la fermeture du transistor de puissance, dès que la tension aux bornes de celui-ci est inférieure à V_{R1} + V_{GSM2}, alors le transistor de protection se ferme. La tension à l'entrée du circuit de servitude est alors l'image de la tension drain-source du transistor de puissance, cette tension étant une image du courant qui traverse le transistor de puissance.

Lorsque le circuit de servitude est un circuit de mesure de courant, la résistance à prendre en compte pour l'évaluation du courant est la première résistance R1 (typiquement d'une valeur de plusieurs kΩ) en parallèle avec la R_{ON} du transistor de puissance, R_{ON} étant la résistance entre le drain et la source du transistor de puissance à l'état passant.

Le dispositif de protection selon la présente invention peut être utilisé dans tous les montages nécessitant de relier un composant de puissance à un circuit de servitude pendant la phase de conduction, par exemple lorsque l'on souhaite mesurer la tension de chute aux bornes du composant de puissance.

Le dispositif de protection selon la présente invention est particulièrement approprié pour être utilisé dans un réseau haute tension, mais pourrait également être utilisé dans un réseau basse ou moyenne tension, la gestion du transistor de protection étant très simple.

Le dispositif de protection selon l'invention pourrait en particulier être adapté au raccordement d'un circuit de servitude assurant une mesure de courant ou bien une mesure de tension.

Selon une caractéristique particulière de la présente invention, chacun des transistors de puissance et de protection est un transistor MOSFET, de préférence de type NMOS.

Il est à noter qu'un ou plusieurs des transistors MOS pourraient également être de type PMOS, sans s'écarter du cadre de la présente invention.

Selon une caractéristique particulière de la présente invention, le dispositif de protection comprend en outre un filtre disposé entre la première source de tension continue et la grille du transistor de protection, ledit filtre comprenant au moins une résistance de filtre et au moins un condensateur de filtre.

Ainsi, ce filtre, permet de stabiliser la grille du transistor de protection lors des transitions (ouverture et fermeture) du transistor de puissance.

Selon une variante de réalisation de la présente invention, le dispositif de protection comprend en outre une source de courant reliée à la source du transistor de protection, ladite source de courant étant configurée pour pré-polariser la première résistance.

Ainsi, pour diminuer le courant de fuite pendant la phase d'ouverture du transistor de puissance, la source de courant permet de pré-polariser la première résistance. Le courant de fuite est alors diminué de manière importante.

Selon une caractéristique particulière de la présente invention, le circuit de servitude comprend en outre un convertisseur analogique-numérique relié à la sortie de l'amplificateur opérationnel.

Ainsi, le convertisseur analogique-numérique permet de convertir la tension de sortie de l'amplificateur opérationnel en une valeur numérique représentant la valeur du courant circulant dans le transistor de puissance à l'état fermé.

Selon un mode de réalisation de la présente invention, l'amplificateur opérationnel est configuré pour être utilisé en tant qu'amplificateur, ledit dispositif comprenant en outre une seconde résistance disposée entre l'entrée inverseuse de l'amplificateur opérationnel et la masse et une troisième résistance disposée entre l'entrée inverseuse de l'amplificateur opérationnel et la sortie de l'amplificateur opérationnel, le gain de l'amplificateur opérationnel dépendant des valeurs des seconde et troisième résistances, la tension à la sortie de l'amplificateur opérationnel étant l'image du courant aux bornes du transistor de puissance lorsque ce dernier est fermé.

Ainsi, la résistance R_{ON} du transistor de puissance est utilisée pour mesurer le courant circulant dans le transistor de puissance. L'amplificateur opérationnel permet d'amplifier la tension présente sur son entrée non inverseuse. Le choix des valeurs des seconde et troisième résistances permet de définir le gain de l'amplificateur opérationnel, ledit gain étant choisi en fonction de la plage de tension souhaitée à la sortie de l'amplificateur opérationnel.

Selon un autre mode de réalisation de la présente invention, l'amplificateur opérationnel est configuré pour être utilisé en tant que comparateur afin de détecter un court-circuit dans le circuit électrique, une seconde source de tension étant reliée à l'entrée inverseuse de l'amplificateur opérationnel, la sortie de l'amplificateur opérationnel indiquant un sur-courant dans le transistor de puissance lorsque la tension à l'entrée non inverseuse de l'amplificateur opérationnel est supérieure à la tension de la seconde source de tension.

Ainsi, dans ce cas, le dispositif de mesure de courant permet de détecter un sur-courant dans le transistor de puissance.

Le temps de réponse du dispositif étant très rapide, il est ainsi possible d'utiliser ce dispositif pour détecter un court-circuit de la charge disposée en amont ou en aval du transistor de puissance au moment de la fermeture ou pendant la fermeture du transistor de puissance, ou pour détecter un court-circuit d'un bras dans un onduleur ou tout autre convertisseur de puissance.

Le comparateur peut, par exemple, provoquer l'ouverture du transistor de puissance lorsque la tension au niveau de l'entrée non inverseuse de l'amplificateur opérationnel dépasse la tension de la seconde source de tension.

La présente invention a également pour objet un ensemble circuit électrique - dispositif de mesure de courant, comprenant un circuit électrique et un dispositif de mesure de courant tel que défini ci-dessus, ledit circuit électrique étant l'un parmi un contrôleur de puissance à semi-conducteurs et un onduleur.

Ainsi, le dispositif de mesure de courant permet de mesurer le courant circulant dans le circuit électrique même dans le cas d'un réseau haute tension.

Pour mieux illustrer l'objet de la présente invention, on va en décrire ci-après, à titre illustratif et non limitatif, deux modes de réalisation préférés, avec référence aux dessins annexés.

Sur ces dessins :
- [Fig. 1] est un schéma de principe d'un dispositif de mesure de courant selon l'état antérieur de la technique ;
- [Fig. 2] est un schéma de principe d'un dispositif de mesure de courant incorporant un dispositif de protection selon un premier mode de réalisation de la présente invention ;
- [Fig. 3] est un schéma de principe d'un dispositif de mesure de courant incorporant un dispositif de protection selon un second mode de réalisation de la présente invention ;
   [Fig. 4] est un schéma montrant, en concordance temporelle, différentes courbes de tension ou d'intensité mesurées dans un exemple de réalisation du dispositif selon l'invention.

Si l'on se réfère à la Figure 2, on peut voir qu'il y est représenté un dispositif de mesure de courant incorporant un dispositif de protection P selon un premier mode de réalisation de la présente invention.

Le dispositif de mesure du courant circulant dans un circuit électrique, réalise la mesure du courant qui circule dans un transistor de puissance M1 (ici un transistor MOSFET de type N, plus communément désigné transistor NMOS) de ce circuit électrique. Un tel transistor de puissance M1 est, par exemple, un contacteur statique à semi-conducteurs d'un circuit alimentant une charge disposée en amont ou en aval du transistor de puissance M1. Le point M est la masse ou pôle commun des circuits de pilotage à distinguer de la masse de la partie puissance (masse non représentée). Ce transistor de puissance M1 a son ouverture et sa fermeture commandées par un dispositif de commande classique et non représenté. Ce dispositif de commande agit sur la grille du transistor de puissance M1.

Ces transistors MOS sont utilisés en particulier dans les contrôleurs de puissance à semi-conducteurs, aussi appelés SSPC (acronyme de leur dénomination anglaise « Solid State Power Controller »). Ces contrôleurs ont pour but d'alimenter une charge en un courant avec des caractéristiques de tension et de puissance données. Ces dispositifs permettent de commander l'ouverture de circuits fonctionnant avec des tensions importantes (de 12 Volts à 1000 Volts) et avec des intensités de quelques centaines d'ampères pendant la phase de fermeture et d'ouverture.

Le circuit électrique à mesurer pourrait également être un onduleur, sans s'écarter du cadre de la présente invention.

Le transistor de puissance M1 est incorporé en série dans le circuit électrique de type SSPC entre une entrée du SSPC (Entrée-SSPC) et une sortie du SSPC (Sortie-SSPC), la sortie (Sortie-SSPC) étant reliée à la masse M. Une tension Vin est ainsi mesurée entre le drain et la source du transistor de puissance M1.

Lorsque le transistor de puissance M1 est à l'état passant, sa résistance interne entre son drain et sa source (communément appelée R_{ON}) est parcourue par un courant.

Le dispositif de mesure de courant comprend en outre un amplificateur opérationnel U1. Le dispositif de mesure incorpore aussi un dispositif de protection P selon l'invention qui comprend : un transistor de protection M2 de type NMOS dont le drain est relié au drain du transistor de puissance M1 et dont la source est reliée au circuit de servitude Z qui est ici un circuit de mesure de courant comprenant l'amplificateur opérationnel U1. Ainsi le drain du transistor de protection M2 est relié à l'entrée non inverseuse de l'amplificateur opérationnel U1.

Le circuit de protection P comprend aussi une première source de tension continue V1 qui est reliée en permanence à la grille du transistor de protection M2, et une première résistance R1 dont l'une des bornes est reliée à la source du transistor de protection M2 et dont l'autre des bornes est reliée à la masse M.

Dans l'application de mesure de courant qui est décrite ici, l'entrée inverseuse de l'amplificateur opérationnel U1 est configurée de telle sorte que la tension à la sortie de l'amplificateur opérationnel U1 est fonction du courant aux bornes du transistor de puissance M1 lorsque ce dernier est fermé.

Dans le dispositif selon la présente invention, le transistor de protection M2 reste automatiquement ouvert tant que la tension Vin aux bornes du transistor de puissance M1 est trop importante pour l'entrée du circuit de servitude, ici l'entrée non inverseuse de l'amplificateur opérationnel U1. C'est le cas en particulier lorsque le transistor de puissance M1 est lui-même ouvert.

Quand le transistor de puissance M1 est ouvert, un courant Iin s'établit à travers le transistor de protection M2 afin de respecter l'équation suivante : V_{GSM2} = V1 - V_{R1}, où V_{GSM2} est la tension entre la grille et la source du transistor de protection M2, V1 est la tension continue de la première source de tension continue V1, et V_{R1} est la tension aux bornes de la première résistance R1. Le point d'équilibre est atteint lorsque la tension V_{GSM2} est égale à la tension de seuil de grille du transistor de protection M2. Le choix de la valeur de la tension de la première source de tension continue V1 et de la valeur de la première résistance R1 permet ainsi de limiter la tension V_{R1} à une tension acceptable pour l'entrée du circuit de servitude Z, ici l'entrée non inverseuse de l'amplificateur opérationnel U1.

Au moment de la fermeture du transistor de puissance M1, dès que la tension aux bornes de celui-ci est inférieure à V_{R1} + V_{GSM2}, alors le transistor de protection M2 se ferme automatiquement. La tension à l'entrée non inverseuse de l'amplificateur opérationnel U1 est alors l'image de la tension drain-source Vin du transistor de puissance M1, cette tension Vin étant une image du courant qui traverse le transistor de puissance M1.

Dans cette application à un dispositif de mesure de courant, la résistance à prendre en compte pour l'évaluation du courant est la première résistance R1 (typiquement d'une valeur de plusieurs kΩ) en parallèle avec la R_{ON} du transistor de puissance M1, R_{ON} étant la résistance entre le drain et la source du transistor de puissance M1 à l'état passant.

La première résistance R1 et le transistor de protection M2 permettent de limiter le courant de fuite Iin pendant la phase d'ouverture du transistor de puissance M1.

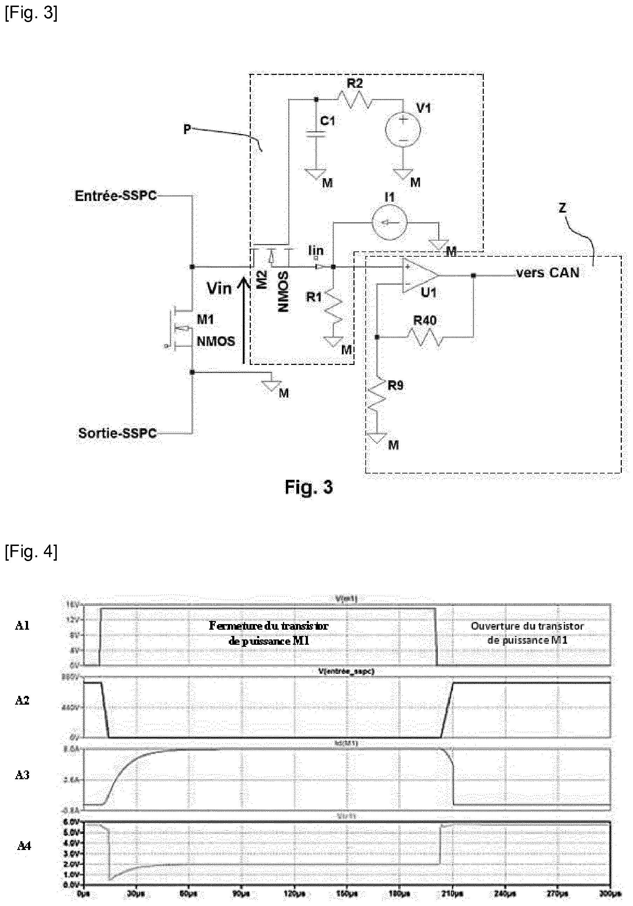

La Figure 4 donne différentes courbes permettant d'expliciter le fonctionnement du dispositif selon l'invention. La courbe supérieure (A1) montre la tension de commande de grille du transistor de puissance M1 (VM1) en fonction du temps et comporte une zone de fermeture de M1 suivie d'une zone d'ouverture de M1. La courbe suivante (A2) montre la tension Vin en entrée du transistor de puissance M1. On remarque que lorsque le transistor de puissance est ouvert, cette tension d'entrée est forte (ici de l'ordre de 800 volts). La courbe suivante (A3) donne le courant ld(M1) circulant dans le transistor de puissance M1. Le courant augmente progressivement pour se stabiliser ici à environ 8 Ampères. Enfin la courbe du bas (A4) donne la tension aux bornes de la résistance R1 qui donne une image du courant ld(M1). On remarque que le courant de 8 ampères est ici représenté par une tension d'environ 2 volts. On remarque que cette tension adopte rapidement une valeur fixe de 6 volts dès l'ouverture du transistor de puissance M1. Cette valeur correspond à celle donnée par la source de tension V1. Le transistor de protection M2 étant passé à l'état ouvert.

Le dispositif selon la présente invention est particulièrement approprié pour être utilisé dans un réseau haute tension, mais pourrait également être utilisé dans un réseau basse ou moyenne tension, sans s'écarter du cadre de la présente invention.

Il est à noter que les transistors MOS M1 ou M2 pourraient également être de type PMOS, sans s'écarter du cadre de la présente invention.

Le dispositif de protection P mis en oeuvre dans ce dispositif de mesure de courant comprend en outre un filtre disposé entre la première source de tension continue V1 et la grille du transistor de protection M2, ledit filtre comprenant une résistance de filtre R2, disposée entre la première source de tension continue V1 et la grille du transistor de protection M2, et un condensateur de filtre C1, disposé entre la grille du transistor de protection M2 et la masse M, ledit filtre permettant ainsi de stabiliser la grille du transistor de protection M2 lors des transitions (ouverture et fermeture) du transistor de puissance M1.

La sortie de l'amplificateur opérationnel U1 est reliée à un convertisseur analogique-numérique (CAN) configuré pour convertir la tension de sortie de l'amplificateur opérationnel U1 en une valeur numérique représentant la valeur du courant circulant dans le transistor de puissance M1 à l'état fermé.

L'amplificateur opérationnel U1 est ici configuré pour être utilisé en tant qu'amplificateur de tension, une seconde résistance R9 étant disposée entre son entrée inverseuse et la masse M, et une troisième résistance R40 (résistance de contre-réaction) étant disposée entre son entrée inverseuse et sa sortie, le gain G de l'amplificateur opérationnel U1 dépendant alors des valeurs des résistances R9 et R40 selon l'équation G = 1 + R40 / R9.

La tension à la sortie de l'amplificateur opérationnel U1 est une image du courant circulant dans le transistor de puissance M1 lorsque ce dernier est fermé, selon l'équation Vs = G * Vin = G * R_{ON} * I_{M1}, où Vs est la tension de sortie de l'amplificateur opérationnel U1, G est le gain de l'amplificateur opérationnel U1, Vin à la tension drain-source du transistor de puissance M1, R_{ON} est la résistance drain-source du transistor de puissance M1 à l'état passant, et I_{M1} est le courant circulant dans le transistor M1 lorsque ce dernier est fermé.

Ainsi, la résistance R_{ON} du transistor de puissance M1 est utilisée pour mesurer le courant circulant dans le transistor de puissance M1. L'amplificateur opérationnel U1 permet d'amplifier la tension présente sur son entrée non inverseuse. Le choix des valeurs des seconde et troisième résistances R9, R40 permet de définir le gain G de l'amplificateur opérationnel U1, ledit gain G étant choisi en fonction de la plage de tension souhaitée à la sortie de l'amplificateur opérationnel U1.

Il est à noter que l'amplificateur opérationnel U1 pourrait également être configuré pour être utilisé en tant que comparateur afin de détecter un court-circuit dans le circuit électrique, sans s'écarter du cadre de la présente invention, auquel cas l'entrée inverseuse de l'amplificateur opérationnel U1 est uniquement reliée à une seconde source de tension, la sortie de l'amplificateur opérationnel U1 indiquant alors un sur-courant dans le transistor de puissance M1 lorsque la tension sur l'entrée non inverseuse de l'amplificateur opérationnel U1 est supérieure à la tension de la seconde source de tension.

Si l'on se réfère à la Figure 3, on peut voir qu'il y est représenté un dispositif de mesure de courant incorporant un dispositif de protection P selon un second mode de réalisation de la présente invention.

Le dispositif de protection P selon ce second mode de réalisation de l'invention est identique au dispositif de protection selon le premier mode de réalisation de l'invention représenté à la Figure 2, à l'exception du fait que le dispositif de protection P selon le second mode de réalisation comprend en outre une source de courant I1 reliée à la source du transistor de protection M2, ladite source de courant I1 étant configurée pour pré-polariser la première résistance R1.

Ainsi, pour diminuer le courant de fuite Iin pendant la phase d'ouverture du transistor de puissance M1, la source de courant I1 permet de pré-polariser la première résistance R1. Le courant de fuite Iin est alors diminué de manière importante.

Les autres composants du circuit de servitude Z protégés par le dispositif de protection sont identiques à ceux décrits précédemment en référence à la Figure 2. Le circuit de servitude qui assure la mesure du courant comprend ainsi un amplificateur opérationnel U1 configuré en amplificateur de tension, une seconde résistance R9 étant disposée entre son entrée inverseuse et la masse M, et une troisième résistance R40 (résistance de contre-réaction) étant disposée entre son entrée inverseuse et sa sortie.

Dans les exemples qui ont été donnés, on s'est limité à décrire le dispositif de protection selon l'invention dans son application à la protection d'un circuit de servitude qui assure la mesure du courant circulant dans un circuit de puissance.

Il est bien entendu qu'un tel dispositif de protection pourrait être associé à un circuit de servitude assurant une mesure de la tension.

Le dispositif de protection pourrait également être utilisé pour protéger un circuit de servitude raccordé à un circuit d'alimentation électrique.

## Revendications

1. Dispositif de mesure de courant dans un circuit électrique de puissance, configuré pour mettre en oeuvre un dispositif de protection (P) et un circuit de servitude (Z) raccordé au circuit électrique de puissance comprenant un transistor de puissance (M1) incorporé en série dans le circuit électrique de puissance et à une borne duquel est relié le circuit de servitude (Z), ledit dispositif de protection (P) comprenant un transistor de protection (M2) dont le drain est configuré pour être relié au drain du transistor de puissance (M1) et dont la source est configurée pour être reliée au circuit de servitude (Z), et une première résistance (R1) dont l'une des bornes est reliée à la source du transistor de protection (M2) et dont l'autre des bornes est reliée à la masse (M), ledit dispositif de protection (P) comprenant en outre une première source de tension continue (V1) reliée en permanence à la grille du transistor de protection (M2), le circuit de servitude (Z) comprenant en outre un circuit de mesure de courant comprenant au moins un amplificateur opérationnel (U1) dont l'entrée non inverseuse est reliée à la source du transistor de protection (M2), l'entrée inverseuse de l'amplificateur opérationnel (U1) étant configurée de telle sorte que la tension à la sortie de l'amplificateur opérationnel (U1) est fonction du courant aux bornes du transistor de puissance (M1) lorsque ce dernier est fermé,.

2. Dispositif de mesure de courant selon la revendication 1, **caractérisé par le fait que** chacun des transistor de puissance (M1) et de protection (M2) est un transistor MOSFET, de préférence de type NMOS.

3. Dispositif de mesure de courant selon la revendication 1 ou 2, **caractérisé par le fait qu'**il comprend en outre un filtre disposé entre la première source de tension continue (V1) et la grille du transistor de protection (M2), ledit filtre comprenant au moins une résistance de filtre (R2) et au moins un condensateur de filtre (C1).

4. Dispositif de mesure de courant selon l'une des revendications 1 à 3, **caractérisé par le fait qu'**il comprend en outre une source de courant (11) reliée à la source du transistor de protection (M2), ladite source de courant (11) étant configurée pour pré-polariser la première résistance (R1).

5. Dispositif de mesure de courant selon l'une des revendications 1 à 4, **caractérisé par le fait qu'**il comprend en outre un convertisseur analogique-numérique (CAN) relié à la sortie de l'amplificateur opérationnel (U1).

6. Dispositif de mesure de courant selon l'une des revendications 1 à 5, **caractérisé par le fait que** l'amplificateur opérationnel (U1) est configuré pour être utilisé en tant qu'amplificateur, ledit dispositif comprenant en outre une seconde résistance (R9) disposée entre l'entrée inverseuse de l'amplificateur opérationnel (U1) et la masse (M) et une troisième résistance (R40) disposée entre l'entrée inverseuse de l'amplificateur opérationnel (U1) et la sortie de l'amplificateur opérationnel (U1), le gain de l'amplificateur opérationnel (U1) dépendant des valeurs des seconde (R9) et troisième (R40) résistances, la tension à la sortie de l'amplificateur opérationnel (U1) étant l'image du courant aux bornes du transistor de puissance (M1) lorsque ce dernier est fermé.

7. Dispositif de mesure de courant selon l'une des revendications 1 à 6, **caractérisé par le fait que** l'amplificateur opérationnel (U1) est configuré pour être utilisé en tant que comparateur afin de détecter un court-circuit dans le circuit électrique, une seconde source de tension étant reliée à l'entrée inverseuse de l'amplificateur opérationnel (U1), la sortie de l'amplificateur opérationnel (U1) indiquant un sur-courant dans le transistor de puissance (M1) lorsque la tension à l'entrée non inverseuse de l'amplificateur opérationnel (U1) est supérieure à la tension de la seconde source de tension.

8. Ensemble circuit électrique - dispositif de mesure de courant, comprenant un circuit électrique et un dispositif de mesure de courant selon l'une des revendications 1 à 7, ledit circuit électrique étant l'un parmi un contrôleur de puissance à semi-conducteurs et un onduleur.

## Patentansprüche

1. - Strommessvorrichtung in einem elektrischen Leistungskreis, die dazu ausgelegt ist, eine Schutzvorrichtung (P) und einen Nebenverbraucherkreis (Z) umzusetzen, der an den elektrischen Leistungskreis angeschlossen ist, umfassend einen Leistungstransistor (M1), der in Reihe in den elektrischen Leistungskreis implementiert ist, und an einer Klemme desselben der Nebenverbraucherkreis (Z) verbunden ist, wobei die Schutzvorrichtung (P) einen Schutztransistor (M2) umfasst, dessen Drain dazu ausgelegt ist, mit dem Drain des Leistungstransistors (M1) verbunden zu sein und dessen Quelle dazu ausgelegt ist, mit dem Nebenverbraucherkreis (Z) verbunden zu sein, und einen ersten Widerstand (R1), von dem die eine der Klemmen mit der Quelle des Schutztransistors (M2) verbunden ist und dessen andere Quelle mit der Masse (M) verbunden ist, wobei die Schutzvorrichtung (P) ferner eine erste Gleichspannungsquelle (V1) umfasst, die ständig mit dem Gitter des Schutztransistors (M2) verbunden ist, wobei der Nebenverbraucherkreis (Z) ferner einen Strommesskreis umfasst, der mindestens einen operativen Verstärker (U1) umfasst, dessen nichtinvertierender Eingang mit der Quelle des Schutztransistors (M2) verbunden ist, wobei der invertierende Eingang des operativen Verstärkers (U1) dazu ausgelegt ist, dass die Spannung am Ausgang des operativen Verstärkers (U1) vom Strom an den Klemmen des Leistungstransistors (M1) abhängt, wenn dieser geschlossen ist.

2. - Strommessvorrichtung (P) nach Anspruch 1, **dadurch gekennzeichnet, dass** sowohl der Leistungs- (M1) als auch der Schutztransistor (M2) ein MOSFET-Transistor, vorzugsweise vom NMOS-Typ, ist.

3. - Strommessvorrichtung (P) nach Anspruch 1 oder 2, **dadurch gekennzeichnet, dass** er ferner einen Filter umfasst, der zwischen der ersten Gleichspannungsquelle (V1) und dem Gitter des Schutztransistors (M2) angeordnet ist, wobei der Filter mindestens einen Filterwiderstand (R2) und mindestens einen Filterkondensator (C1) umfasst.

4. - Strommessvorrichtung (P) nach einem der Ansprüche 1 bis 3, **dadurch gekennzeichnet, dass** sie ferner eine Stromquelle (I1) umfasst, die mit der Quelle des Schutztransistors (M2) verbunden ist, wobei die Stromquelle (I1) dazu ausgelegt ist, den ersten Widerstand (R1) vorzupolarisieren.

5. - Strommessvorrichtung nach einem der Ansprüche 1 bis 4, **dadurch gekennzeichnet, dass** sie ferner einen Analog-Digital-Wandler (CAN) umfasst, der mit dem Ausgang des operativen Verstärkers (U1) verbunden ist.

6. - Strommessvorrichtung nach einem der Ansprüche 1 bis 5, **dadurch gekennzeichnet, dass** der operative Verstärker (U1) dazu ausgelegt ist, als Verstärker verwendet zu werden, wobei die Vorrichtung ferner einen zweiten Widerstand (R9) umfasst, der zwischen dem invertierenden Eingang des operativen Verstärkers (U1) und der Masse (M) angeordnet ist und einen dritten Widerstand (R40), der zwischen dem invertierenden Eingang des operativen Verstärkers (U1) und dem Ausgang des operativen Verstärkers (U1) angeordnet ist, wobei der Gain des operativen Verstärkers (U1) von den Werten des zweiten (R9) und dritten (R40) Widerstands abhängt, wobei die Spannung am Ausgang des operativen Verstärkers (U1) das Image des Stroms an den Klemmen des Leistungstransistors (M1) ist, wenn dieser geschlossen ist.

7. - Strommessvorrichtung nach einem der Ansprüche 1 bis 6, **dadurch gekennzeichnet, dass** der operative Verstärker (U1) dazu ausgelegt ist, als Komparator verwendet zu werden, um einen Kurzschluss im Stromkreis zu ermitteln, wobei eine zweite Spannungsquelle mit dem invertierenden Eingang des operativen Verstärkers (U1) verbunden ist, wobei der Ausgang des operativen Verstärkers (U1) einen Überstrom im Leistungstransistor (M1) anzeigt, wenn die Spannung am nichtinvertierenden Eingang des operativen Verstärkers (U1) höher als die Spannung der zweiten Spannungsquelle ist.

8. - Anordnung Stromkreis - Strommessvorrichtung, umfassend einen Stromkreis und eine Strommessvorrichtung nach einem der Ansprüche 1 bis 7, wobei der Stromkreis entweder ein Leistungsregler mit Halbleitern oder ein Wechselrichter ist.

## Claims

1. - A device for measuring a current in an electric power circuit, configured to implement a protection device (P) and a utility circuit (Z) connected to the electric power circuit comprising a power transistor (M1) incorporated in series in the electric power circuit and a terminal of which is connected to the utility circuit (Z), said protection device (P) comprising a protection transistor (M2) whose drain is configured to be connected to the drain of the power transistor (M1) and whose source is configured to be connected to the utility circuit (Z), and a first resistor (R1), one of the terminals of which is connected to the source of the protection transistor (M2) and the other of the terminals of which is connected to the ground (M), said protection device (P) further comprising a first DC voltage source (V1) permanently connected to the gate of the protection transistor (M2), the utility circuit (Z) further comprising a current measuring circuit comprising at least one operational amplifier (U1) whose noninverting input is connected to the source of the protection transistor (M2), the inverting input of the operational amplifier (U1) being configured such that the voltage at the output of the operational amplifier (U1) is a function of the current across the terminals of the power transistor (M1) when the latter is closed.

2. - The current measuring device according to claim 1, **characterized in that** each of the power transistor (M1) and protection transistor (M2) is a MOSFET transistor, preferably of the NMOS type.

3. - The current measuring device according to claim 1 or 2, **characterized in that** it further comprises a filter arranged between the first DC voltage source (V1) and the gate of the protection transistor (M2), said filter comprising at least one filter resistor (R2) and at least one filter capacitor (C1).

4. - The current measuring device according to one of claims 1 to 3, **characterized in that** it further comprises a current source (I1) connected to the source of the protection transistor (M2), said current source (I1) being configured to pre-polarize the first resistor (R1).

5. - The current measuring device according to one of claims 1 to 4, **characterized in that** it further comprises an analog-digital converter (ADC) connected to the output of the operational amplifier (U1).

6. - The current measuring device according to one of claims 1 to 5, **characterized in that** the operational amplifier (U1) is configured to be used as amplifier, said device further comprising a second resistor (R9) arranged between the inverting input of the operational amplifier (U1) and the ground (M) and a third resistor (R40) arranged between the inverting input of the operational amplifier (U1) and the output of the operational amplifier (U1), the gain of the operational amplifier (U1) depending on the values of the second (R9) and third (R40) resistors, the voltage at the output of the operational amplifier (U1) being the image of the current across the terminals of the power transistor (M1) when the latter is closed.

7. - The current measuring device according to one of claims 1 to 6, **characterized in that** the operational amplifier (U1) is configured to be used as comparator so as to detect a short-circuit in the electric circuit, a second voltage source being connected to the inverting input of the operational amplifier (U1), the output of the operational amplifier (U1) indicating an overcurrent in the power transistor (M1) when the voltage at the noninverting input of the operational amplifier (U1) is greater than the voltage of the second voltage source.

8. - An electric circuit-current measuring device assembly, comprising an electric circuit and a current measuring device according to one of claims 1 to 7, said electric circuit being chosen among a semiconductor power controller and an inverter.
